# FASCICULE DE BREVET EUROPEEN

(11) **EP 3 457 224 B1**
(45) Date de publication et mention de la délivrance du brevet: **28.10.2020**
(21) Numéro de dépôt: 17191148.0
(22) Date de dépôt: 14.09.2017
(51) Int. Cl.: G04C 3/04, G04B 17/06, G04B 17/22

(54) **ELEMENT PIEZOELECTRIQUE POUR UN CIRCUIT D'AUTOREGULATION DE FREQUENCE, SYSTEME MECANIQUE OSCILLANT ET DISPOSITIF LE COMPRENANT, ET PROCEDE DE FABRICATION DE L'ELEMENT PIEZOELECTRIQUE**
PIEZOELEKTRISCHES ELEMENT FÜR EINEN SCHALTKREIS ZUR FREQUENZSELBSTREGULIERUNG, SCHWINGENDES MECHANISCHES SYSTEM UND DIESES UMFASSENDE VORRICHTUNG, UND HERSTELLUNGSVERFAHREN EINES SOLCHEN PIEZOELEKTRISCHEN ELEMENTS
PIEZOELECTRIC ELEMENT FOR A FREQUENCY SELF-REGULATION CIRCUIT, OSCILLATING MECHANICAL SYSTEM AND DEVICE INCLUDING THE SAME, AND METHOD FOR MANUFACTURING THE PIEZOELECTRIC ELEMENT

(43) Date de publication de la demande: 20.03.2019
(73) Titulaire: The Swatch Group Research and Development Ltd, 2074 Marin (CH)
(72) Inventeur: HAEMMERLI, Alexandre, 2000 Neuchâtel (CH); GUEISSAZ, François, 2036 Cormondrèche (CH); TOMBEZ, Lionel, 2000 Neuchâtel (CH); SCHNYDER, Bernhard, 3297 Leuzigen (CH); DALLA PIAZZA, Silvio, 2610 St-Imier (CH)
(74) Mandataire: ICB SA

(56) Documents cités:
- CH-A2- 705 679
- CH-A2- 710 603
- US-B2- 8 721 169

## Description

### DOMAINE TECHNIQUE DE L'INVENTION

L'invention concerne un élément piézoélectrique pour un circuit d'autorégulation de fréquence.

L'invention concerne également un système mécanique oscillant comprenant l'élément piézoélectrique et un balancier.

L'invention concerne en outre un dispositif comprenant le système mécanique oscillant et un circuit d'autorégulation de la fréquence d'oscillation du système mécanique oscillant.

L'invention concerne également un procédé de fabrication de l'élément piézoélectrique.

### ETAT DE LA TECHNIQUE

Des éléments piézoélectriques sont communément utilisés dans le domaine des systèmes électromécaniques, par exemple pour la confection d'oscillateurs utilisés comme base de temps, ou encore pour des applications de capteurs de masse, force, gyroscope et bien d'autres.

Dans le domaine de l'horlogerie, et notamment des montres mécaniques ou électromécaniques, il est connu de munir un système mécanique oscillant d'un élément piézoélectrique. Le système mécanique oscillant peut typiquement comprendre un balancier sur lequel est monté un ressort spiral, dont une extrémité est fixée à l'axe de rotation du balancier et l'autre extrémité est fixée sur un élément fixe d'une platine. Le système mécanique est maintenu en oscillation par l'intermédiaire d'une source d'énergie généralement mécanique. Cette source d'énergie peut être par exemple un barillet entraînant un train d'engrenages avec une roue d'échappement coopérant avec une ancre. Cette ancre rotative actionne par exemple une cheville fixée à proximité de l'axe de rotation du balancier. Le balancier avec le ressort spiral peut ainsi former un organe régulateur d'un mouvement d'horlogerie. Cet organe régulateur oscillant détermine la vitesse d'entraînement du train d'engrenages avec la roue d'échappement conduisant aux aiguilles d'indication de l'heure. L'élément piézoélectrique peut comprendre le ressort spiral, sur lequel il est connu de déposer des pellicules d'un matériau piézoélectrique (de type PZT), par exemple sur les faces intérieure et extérieure du ressort. A ce titre, on peut citer les demandes de brevet JP 2002-228774 ou EP 2 590 035 A1. Toutefois, le dépôt de telles pellicules de matériau piézoélectrique sur toute la longueur du ressort spiral introduit une étape supplémentaire coûteuse dans la fabrication du ressort, ce qui est un désavantage.

Dans ces deux demandes de brevet, le réglage de la fréquence d'oscillation du balancier combiné au ressort spiral piézoélectrique est effectué au moyen d'un circuit électronique d'autorégulation de fréquence. Le circuit électronique peut être alimenté directement par la tension alternative générée par l'élément piézoélectrique, qui a été redressée et stockée sur un condensateur. Pour le réglage de la fréquence d'oscillation, il est effectué une comparaison entre un signal à fréquence de référence fourni par un étage oscillateur, et le signal alternatif du générateur. Sur la base de cette comparaison, un signal d'adaptation de fréquence est généré, qui, une fois appliqué à l'élément piézoélectrique, permet d'induire une force de compression ou d'extension sur cet élément pour freiner ou accélérer l'oscillation du système mécanique oscillant.

Un autre exemple d'un dispositif comprenant un système mécanique oscillant muni d'un élément piézoélectrique, et un circuit d'autorégulation de la fréquence d'oscillation du système mécanique oscillant, est fourni par la demande de brevet WO 2011/131784 A1. Selon un exemple de réalisation particulier de ce dispositif, l'élément piézoélectrique comprend un ressort spiral formé d'une bande en matériau piézoélectrique, une première électrode disposée sur une face intérieure du ressort, et une deuxième électrode disposée sur une face extérieure du ressort. Les électrodes sont reliées au circuit d'autorégulation de fréquence. Toutefois, un inconvénient de l'élément piézoélectrique proposé est qu'il ne permet pas d'utiliser l'effet piézoélectrique de l'élément de manière précise et optimale, sans devoir complexifier considérablement la conception du système. Les documents US 8 721 169 B2, CH 710 603 A2 et CH 705 679 A2 concernent un élément piézoélectrique pour un circuit d'autorégulation de fréquence, ainsi qu'un dispositif comprenant un tel élément.

### RÉSUMÉ DE L'INVENTION

L'invention a donc pour but de fournir un élément piézoélectrique pour un circuit d'autorégulation de fréquence, simple à réaliser et permettant d'utiliser l'effet piézoélectrique de manière précise et optimale, pour pouvoir réguler précisément la fréquence d'oscillation d'un système mécanique oscillant et pour pallier aux inconvénients susmentionnés de l'état de la technique.

A cet effet, l'invention concerne un élément piézoélectrique pour un circuit d'autorégulation de fréquence, qui comprend les caractéristiques mentionnées dans la revendication indépendante 1.

Des formes particulières de l'élément piézoélectrique sont définies dans les revendications dépendantes 2 à 12.

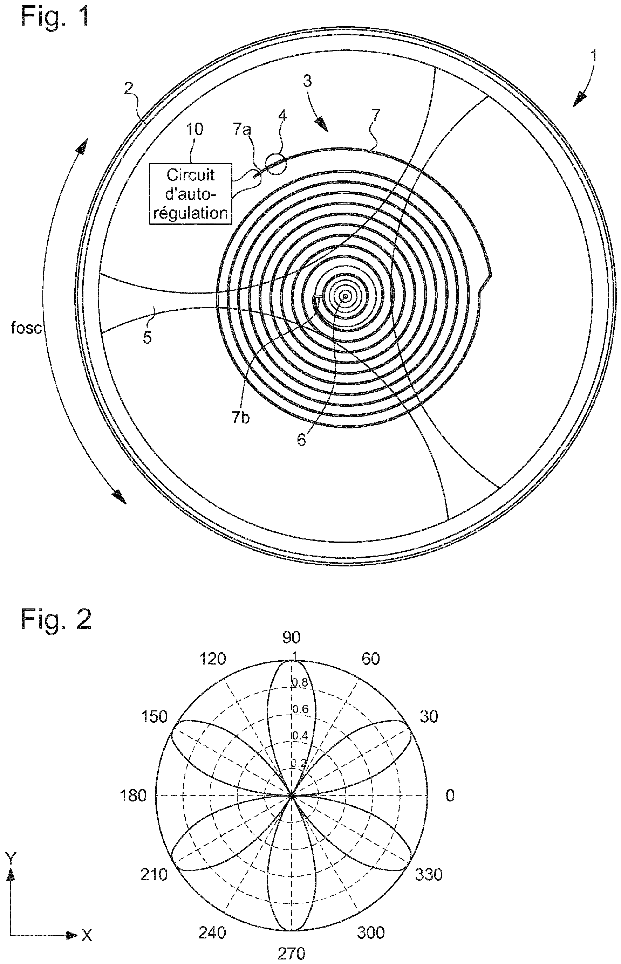

L'utilisation d'un cristal piézoélectrique pour le ressort spiral permet une réalisation simple et économique de l'élément piézoélectrique, tout en conservant de bonnes performances piézoélectriques. En outre, la disposition particulière de couches discontinues d'un matériau isolant séparant une première électrode d'une deuxième électrode, selon une périodicité angulaire prédéterminée sur le ressort spiral, permet aux électrodes de collecter une partie des charges électriques induites par une contrainte mécanique, en surmontant le problème du changement de polarité des charges dû au changement d'orientation cristalline du cristal piézoélectrique. Ce changement de polarité des charges intervient selon une distribution angulaire périodique au sein du ressort spiral. En effet, la structure cristalline du matériau piézoélectrique induit une dépendance du coefficient piézoélectrique à l'orientation de la contrainte mécanique dans un plan horizontal XY. Autrement dit, suivant la direction de la contrainte dans le plan XY, les charges électriques créées peuvent être positives ou négatives, et leur valeur comprise entre une valeur nulle et une valeur maximale, comme illustré par exemple sur la figure 2 dans le cas du quartz. Grâce à l'élément piézoélectrique selon l'invention, le problème de l'annulation des charges électriques positives et négatives dans chacune des électrodes est surmonté. Ceci est possible grâce au découplage des électrodes opéré par les couches discontinues de matériau isolant, permettant à chaque électrode de ne collecter que les charges d'une seule polarité. En outre, du fait de leur géométrie particulièrement simple, la conception et la fabrication des électrodes est aisée. Sans que cela ne soit limitatif dans le cadre de la présente invention, le cristal piézoélectrique est par exemple un monocristal de quartz.

Avantageusement, l'élément piézoélectrique comprend une première rainure creusée dans une première face de la bande en matériau piézoélectrique, et une deuxième rainure creusée dans une deuxième face de la bande en matériau piézoélectrique. La première électrode est disposée dans la première rainure, et la deuxième électrode est disposée dans la deuxième rainure. Ceci permet d'augmenter le couplage capacitif entre les électrodes, et d'ainsi augmenter les performances piézoélectriques de l'élément.

A cet effet, l'invention concerne également un système mécanique oscillant comprenant l'élément piézoélectrique pour un circuit d'autorégulation de fréquence, qui comprend les caractéristiques mentionnées dans la revendication 13.

A cet effet, l'invention concerne également un dispositif comprenant le système mécanique oscillant et le circuit d'autorégulation de la fréquence d'oscillation du système mécanique oscillant, qui comprend les caractéristiques mentionnées dans la revendication 14.

Des formes particulières du dispositif sont définies dans les revendications 15 et 16.

A cet effet, l'invention concerne également un procédé de fabrication de l'élément piézoélectrique pour un circuit d'autorégulation de fréquence, qui comprend les caractéristiques mentionnées dans la revendication 17.

Une forme particulière du procédé est définie dans la revendication 18.

### BRÈVE DESCRIPTION DES FIGURES

Les buts, avantages et caractéristiques de l'élément piézoélectrique pour un circuit d'autorégulation de fréquence, du système mécanique oscillant et du dispositif le comprenant, ainsi que du procédé de fabrication de l'élément, apparaîtront mieux dans la description suivante sur la base d'au moins une forme d'exécution non limitative illustrée par les dessins sur lesquels :
- la figure 1 représente de manière simplifiée un dispositif, qui comprend un système mécanique oscillant muni d'un élément piézoélectrique selon l'invention, et un circuit d'autorégulation de la fréquence d'oscillation du système mécanique oscillant;
- la figure 2 représente un diagramme d'amplitude de l'effet piézoélectrique de l'élément piézoélectrique selon un exemple de réalisation de l'invention, selon l'orientation d'une contrainte dans un plan XY;
- la figure 3 représente de manière simplifiée un exemple de réalisation de l'élément piézoélectrique selon l'invention;
- la figure 4 représente une portion d'un ressort spiral de l'élément piézoélectrique de la figure 3, selon un premier mode de réalisation;
- la figure 5 représente une portion d'un ressort spiral de l'élément piézoélectrique de la figure 3, selon un deuxième mode de réalisation;
- la figure 6 est une vue en coupe de l'élément piézoélectrique de la figure 5, prise selon un plan de coupe VI-VI; et
- la figure 7 représente un schéma bloc simplifié des composants électroniques du circuit d'autorégulation de la figure 1 selon un exemple de réalisation, le circuit étant relié à l'élément piézoélectrique du système mécanique oscillant.

### DESCIRPTION DETAILLEE DE L'INVENTION

Dans la description suivante, il est fait référence à un élément piézoélectrique pour un circuit d'autorégulation de fréquence, notamment un circuit d'autorégulation de la fréquence d'oscillation d'un système mécanique oscillant. Tous les composants électroniques du circuit d'autorégulation de fréquence, qui sont bien connus d'un homme du métier dans ce domaine technique, ne sont décrits que de manière simplifiée. Comme décrit ci-après, le circuit d'autorégulation est principalement utilisé pour réguler la fréquence d'oscillation d'un balancier sur lequel est monté le ressort spiral de l'élément piézoélectrique. Toutefois d'autres systèmes mécaniques oscillants peuvent aussi être envisagés, mais dans la suite de la description il ne sera fait référence qu'à un système mécanique oscillant sous la forme d'un balancier sur lequel est monté le ressort spiral de l'élément piézoélectrique.

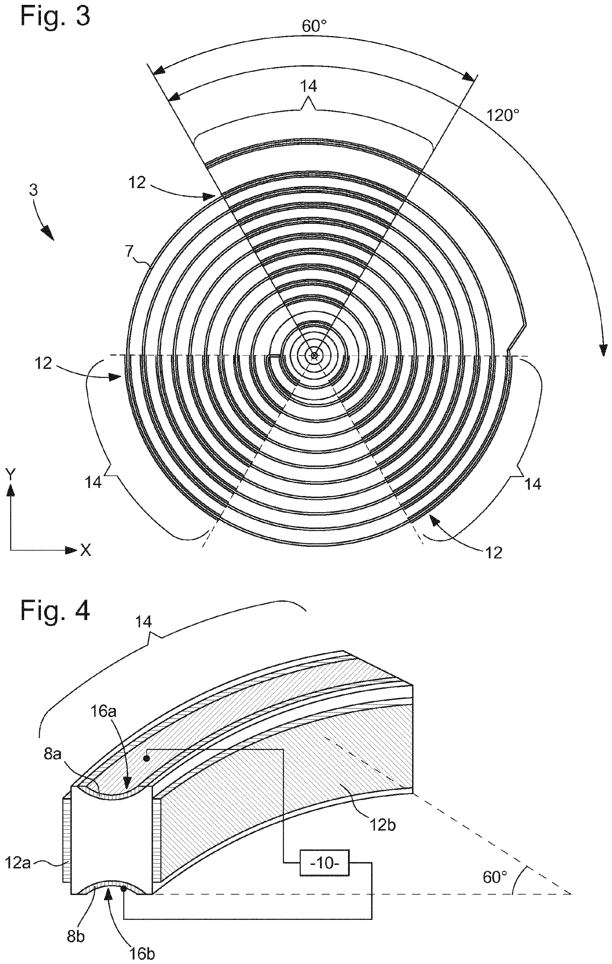

La figure 1 représente un dispositif 1, qui comprend un système mécanique oscillant 2, 3 et un circuit d'autorégulation 10 de la fréquence d'oscillation fosc du système mécanique oscillant. Dans une montre mécanique, le système mécanique oscillant peut comprendre un balancier 2, qui est formé d'un anneau métallique relié par exemple par trois bras 5 à un axe de rotation 6, et un élément piézoélectrique 3, qui comprend un ressort spiral 7. Comme représenté sur les figures 4 à 6, l'élément piézoélectrique 3 comprend en outre au moins deux électrodes 8a-8d et au moins deux couches discontinues 12 d'un matériau isolant. Les électrodes 8a-8d sont reliées électriquement au circuit d'autorégulation de fréquence 10. En revenant à la figure 1, une première extrémité 7a du ressort spiral 7 est maintenue fixe par un piton 4 d'un pont de balancier (non représenté). Ce pont de balancier est fixé à la platine (non représentée) du mouvement de la montre. Une seconde extrémité 7b du ressort spiral 7 est fixée directement sur l'axe de rotation 6 du balancier 2.

Le balancier 2 avec son ressort spiral 7 est maintenu en oscillation par l'intermédiaire d'une source d'énergie (non représentée), qui peut être électrique, mais de préférence mécanique. Cette source d'énergie mécanique peut être un barillet, qui entraîne traditionnellement un train d'engrenages avec une roue d'échappement coopérant avec une ancre. Cette ancre rotative actionne par exemple une cheville fixée à proximité de l'axe de rotation du balancier. Le balancier avec le ressort spiral peut ainsi former un organe régulateur d'un mouvement d'horlogerie.

Le ressort spiral 7 est réalisé au moyen d'une bande en matériau piézoélectrique d'épaisseur généralement inférieure à 0.25 mm, par exemple de l'ordre de 0.1 à 0.2 mm. Le matériau piézoélectrique peut être un cristal piézoélectrique ou une céramique piézoélectrique PZT. De préférence, le cristal piézoélectrique est un monocristal, typiquement du quartz monocristallin dans les exemples de réalisation des figures 2 à 6. La bande en cristal piézoélectrique est par exemple usinée dans du quartz monocristallin de coupe Z, autrement dit de coupe perpendiculaire par rapport à l'axe principal d'un barreau de quartz monocristallin. Au moins deux électrodes métalliques sont ensuite déposées sur des faces distinctes de la bande en cristal piézoélectrique, selon un agencement qui sera décrit plus en détail par la suite. Plus précisément, les électrodes sont disposées sur une partie ou toute la longueur du ressort spiral 7. Chaque électrode est par exemple une électrode du type Au / Cr (Or / Chrome). Au moins deux couches discontinues d'un matériau isolant sont ensuite déposées sur au moins deux faces de la bande en cristal piézoélectrique, selon un agencement qui sera décrit plus en détail par la suite. Chaque couche discontinue de matériau isolant sépare deux électrodes de polarité opposée. Le matériau isolant est par exemple un oxyde. Enfin, la bande en cristal piézoélectrique est enroulée sous la forme d'un spiral avec les spires espacées l'une de l'autre.

Cet usinage du spiral est obtenu par photolithographie et gravure par acide fluorhydrique. Pour ce faire, la plaquette de quartz est d'abord recouverte d'une couche de Cr puis d'Au puis d'une résine photosensible aux UV. La résine est exposée à travers un masque comportant la forme du spiral puis développée dans un produit dédié. Ensuite l'or et le chrome sont gravés par voie humide. Finalement, le quartz est gravé dans un bain d'acide fluorhydrique. La résine est enlevée dans un solvant et le masque en Au/Cr enlevé par voie humide. Par la suite on peut déposer et structurer les électrodes.

La figure 2 représente l'amplitude de l'effet piézoélectrique de l'élément 3 lorsqu'il comprend un ressort spiral 7 en quartz, selon l'orientation d'une contrainte dans un plan horizontal XY. Comme le montre cette figure, la structure cristalline du quartz induit une dépendance du coefficient piézoélectrique à l'orientation de la contrainte mécanique dans le plan XY. Autrement dit, suivant la direction de la contrainte dans le plan XY, les charges électriques créées par le ressort spiral 7 peuvent être positives ou négatives, et leur valeur comprise entre une valeur nulle et une valeur maximale. La structure cristalline du quartz étant trigonale, le maximum des charges électriques se répète tous les 60°, avec un changement de polarité des charges tous les 60° également.

Comme représenté sur la figure 3, les couches discontinues 12 de matériau isolant sont réparties sur des portions prédéterminées 14 du ressort spiral 7. Les portions prédéterminées 14 forment sensiblement des arcs de cercle sur le ressort spiral 7, selon une périodicité angulaire prédéterminée. Dans l'exemple de réalisation préférentiel selon lequel le ressort spiral 7 est formé d'une bande en quartz, la périodicité angulaire prédéterminée est sensiblement égale à 120°. Les arcs de cercle formés par les couches discontinues 12 de matériau isolant définissent chacun un secteur angulaire sensiblement égal à 60°. Autrement dit, selon cet exemple de réalisation préférentiel, en parcourant le ressort spiral 7 selon sa longueur on trouve alternativement, tous les 60°, des portions avec des couches 12 de matériau isolant et des portions dépourvues de telles couches 12. Ainsi, et en référence à la figure 2, l'élément piézoélectrique 3 selon l'invention permet d'éviter l'annulation mutuelle des charges électriques, due au changement de polarité induit par le changement d'orientation cristalline du ressort spiral 7 en quartz. Grâce au découplage des électrodes opéré par les couches discontinues de matériau isolant, les électrodes collectent une partie des charges électriques induites par une contrainte mécanique, en évitant l'annulation mutuelle des charges.

Un premier mode de réalisation de l'invention va maintenant être décrit en référence à la figure 4. Selon ce premier mode de réalisation, l'élément piézoélectrique 3 comprend deux électrodes 8a, 8b et deux couches discontinues 12a, 12b de matériau isolant. Une première électrode 8a parmi les deux électrodes est disposée sur une face de la bande en cristal piézoélectrique désignée face supérieure. Une deuxième électrode 8b est disposée sur une face opposée de la bande désignée face inférieure. Lors de l'enroulement de la bande en cristal piézoélectrique avec les électrodes 8a, 8b, les faces inférieure et supérieure sont perpendiculaires à l'axe de rotation du balancier. De préférence, les deux électrodes 8a, 8b s'étendent sur toute la longueur du ressort spiral 7, bien que seule une portion 14 de ce dernier soit représentée sur la figure 4.

Une première couche discontinue 12a de matériau isolant parmi les deux couches est disposée sur une face de la bande en cristal piézoélectrique désignée face extérieure. Une deuxième couche discontinue 12b de matériau isolant est disposée sur une face opposée de la bande désignée face intérieure. La face intérieure est en regard de l'axe de rotation du balancier, alors que la face extérieure est opposée à la face intérieure. Chaque couche discontinue 12a, 12b de matériau isolant sépare la première électrode 8a de la deuxième électrode 8b. La figure 4 illustre une portion 14 du ressort spiral 7, formant sensiblement un arc de cercle, sur laquelle sont présentes les deux couches 12a, 12b de matériau isolant. Comme indiqué précédemment, dans l'exemple de réalisation préférentiel selon lequel le ressort spiral 7 est formé d'une bande en quartz, cet arc de cercle définit un secteur angulaire sensiblement égal à 60°.

De préférence, l'élément piézoélectrique 3 peut comprendre une première rainure 16a creusée dans une face supérieure de la bande en cristal piézoélectrique, et une deuxième rainure 16b creusée dans une face inférieure. La première électrode 8a est disposée dans la première rainure 16a, et la deuxième électrode 8b est disposée dans la deuxième rainure 16b.

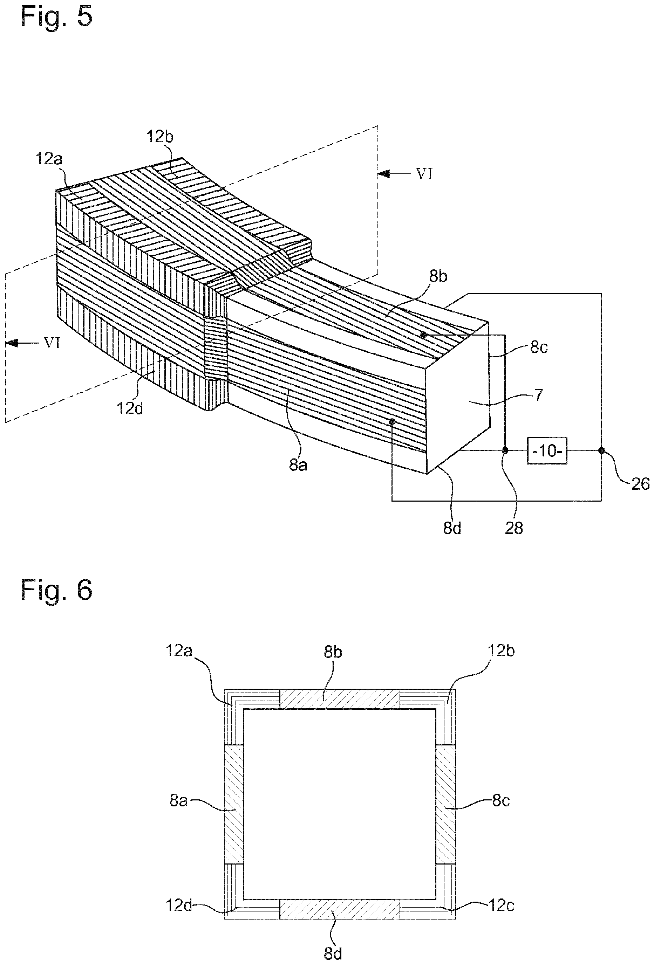

Les figures 5 et 6 illustrent un deuxième mode de réalisation de l'invention pour lequel les éléments analogues au premier mode de réalisation, décrit précédemment, sont repérés par des références identiques, et ne sont donc pas décrits à nouveau.

Dans ce deuxième mode de réalisation, outre les première et deuxième électrodes 8a, 8b, l'élément piézoélectrique 3 comprend également une troisième et une quatrième électrodes 8c, 8d. L'élément piézoélectrique 3 comprend également quatre couches discontinues 12a-12d de matériau isolant. Comme illustré sur la figure 5, la troisième électrode 8c, qui est de la même polarité que la première électrode 8a, est connectée à celle-ci en une première borne de connexion 26. La quatrième électrode 8d, qui est de même polarité que la deuxième électrode 8b, est connectée à celle-ci en une deuxième borne de connexion 28. Les première et deuxième bornes de connexion 26, 28 sont chacune reliées au circuit d'autorégulation de fréquence 10. Dans un exemple de réalisation particulier, non représenté sur les figures, les première et deuxième bornes de connexion 26, 28 sont disposées sur le piton 4 maintenant fixe la première extrémité 7a du ressort spiral 7.

Les première, deuxième, troisième et quatrième électrodes 8a-8d sont disposées respectivement sur les faces extérieure, supérieure, intérieure et inférieure de la bande en cristal piézoélectrique. De préférence, les quatre électrodes 8a-8d s'étendent sur toute la longueur du ressort spiral 7, bien que seule une portion de ce dernier soit représentée sur la figure 5.

Chaque couche discontinue 12a-12d de matériau isolant est disposée à cheval sur deux faces adjacentes de la bande en cristal piézoélectrique. Ainsi, une première couche discontinue 12a de matériau isolant sépare la première électrode 8a de la deuxième électrode 8b. Une deuxième couche discontinue 12b de matériau isolant sépare la deuxième électrode 8b de la troisième électrode 8c. Une troisième couche discontinue 12c de matériau isolant sépare la troisième électrode 8c de la quatrième électrode 8d. Enfin, une quatrième couche discontinue 12d de matériau isolant sépare la quatrième électrode 8d de la première électrode 8a.

Bien que non représentées sur les figures 5 et 6, l'élément piézoélectrique 3 selon ce deuxième mode de réalisation peut avantageusement comprendre des rainures de support d'électrodes, creusées dans des faces opposées de la bande en cristal piézoélectrique.

Lors de l'oscillation du balancier 2 avec le ressort spiral 7, une force de compression ou une force d'extension est appliquée alternativement à la bande en cristal piézoélectrique, qui ensemble génèrent ainsi une tension alternative. La fréquence d'oscillation du balancier 2 avec le ressort spiral 7 peut être située à titre d'exemple typiquement entre 3 et 10 Hz. Le circuit d'autorégulation 10 reçoit donc cette tension alternative, via les électrodes auxquelles il est relié. Le circuit d'autorégulation peut être relié directement ou par l'intermédiaire de deux fils métalliques aux électrodes.

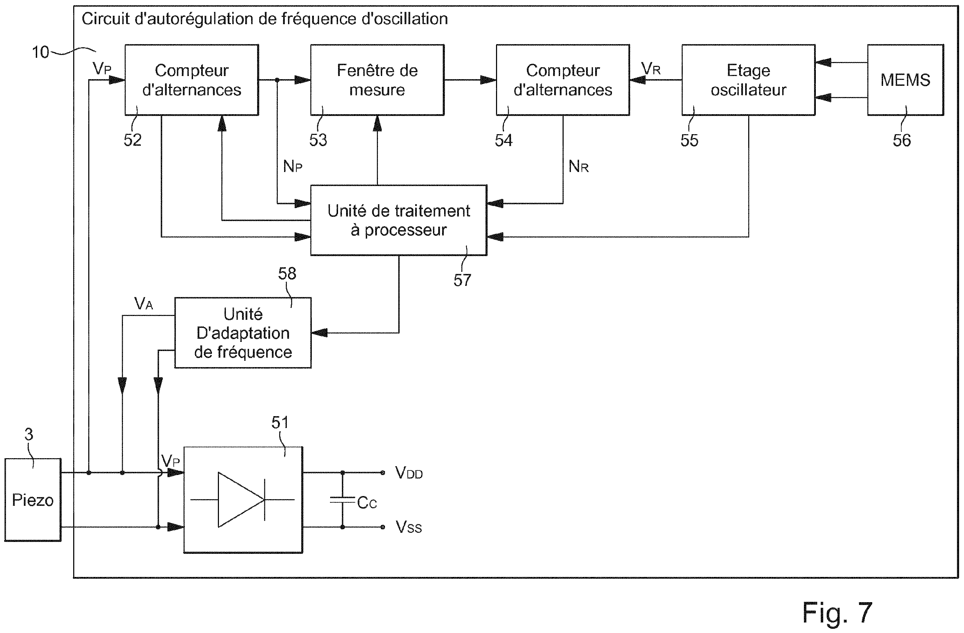

La figure 7 représente les différents éléments électroniques d'un exemple de réalisation du circuit d'autorégulation 10 permettant de réguler la fréquence d'oscillation du système mécanique oscillant. D'autres exemples de circuits d'autorégulation de fréquence peuvent indifféremment être envisagés sans sortir du cadre de l'invention.

Le circuit d'autorégulation 10 est relié à deux électrodes ou groupes d'électrodes de l'élément piézoélectrique 3. Le circuit d'autorégulation 10 est en mesure de redresser la tension alternative VP reçue de l'élément piézoélectrique 3 par l'intermédiaire d'un redresseur 51 traditionnel. La tension redressée de la tension alternative VP est stockée sur un condensateur Cc. Cette tension redressée entre les bornes VDD et VSS du condensateur Cc peut être suffisante pour alimenter tous les éléments électroniques du circuit d'autorégulation sans l'aide d'une source de tension supplémentaire comme une batterie.

Le circuit d'autorégulation 10 comprend un étage oscillateur 55, connecté par exemple à un résonateur du type MEMS 56. Le circuit oscillant de l'étage oscillateur avec le résonateur MEMS fournit un signal oscillant, qui peut être d'une fréquence inférieure à 500 kHz, par exemple de l'ordre de 200 kHz. Ainsi l'étage oscillateur 55 peut fournir de préférence un signal de référence VR, dont la fréquence peut être égale à la fréquence du signal oscillant du circuit oscillateur.

Pour pouvoir réguler la fréquence d'oscillation du système mécanique oscillant, une comparaison doit être effectuée dans le circuit d'autorégulation 10 entre la tension alternative VP et le signal de référence VR. Pour ce faire, le circuit d'autorégulation 10 comprend des moyens de comparaison 52, 53, 54, 57 pour comparer la fréquence de la tension alternative VP avec la fréquence du signal de référence VR. Dans le cas où la fréquence du signal de référence correspond à la fréquence du circuit oscillant de l'étage oscillateur 55, c'est-à-dire à une fréquence de l'ordre de 200 kHz, les moyens de comparaison doivent être conçus de telle manière à tenir compte de l'écart important de fréquence entre la tension alternative VP et le signal de référence VR.

Les moyens de comparaison sont constitués tout d'abord d'un premier compteur d'alternances 52, qui reçoit en entrée la tension alternative VP de l'élément piézoélectrique, et qui fournit un premier signal de comptage NP à une unité de traitement à processeur 57. Les moyens de comparaison comprennent encore un second compteur d'alternances 54, qui reçoit en entrée le signal de référence VR, et qui fournit un second signal de comptage NR à l'unité de traitement à processeur 57.

Pour tenir compte de l'écart de fréquence entre la tension alternative VP et le signal de référence VR, il est prévu encore une fenêtre de mesure 53 disposée entre le premier compteur d'alternances 52 et le second compteur d'alternances 54. Cette fenêtre de mesure 53 détermine le temps de comptage du second compteur d'alternances 54. L'unité de traitement à processeur 57 fournit des paramètres de configuration à la fenêtre de mesure 53 pour déterminer le temps de comptage pour le second compteur d'alternances. Ces paramètres de configuration sont mémorisés dans une mémoire non représentée dans l'unité de traitement à processeur. Ces paramètres de configuration peuvent être différents selon qu'il s'agisse d'une montre pour dame ou d'une montre pour homme. Les différentes opérations traitées dans l'unité de traitement à processeur 57 peuvent être contrôlées par un signal d'horloge fourni par exemple par le circuit oscillant de l'étage oscillateur 55.

Le temps de comptage du second compteur d'alternances 54 est adapté proportionnellement au temps de comptage d'un certain nombre déterminé d'alternances comptées par le premier compteur d'alternances 52 dans le premier signal de comptage NP. L'unité de traitement à processeur 57 peut éventuellement commander aussi le premier compteur d'alternances 52 pour définir le début et la fin d'une période de comptage. Cependant il peut aussi être envisagé que le premier compteur d'alternances 52 fournisse une information du début et de la fin d'un nombre déterminé d'alternances comptées à l'unité de traitement à processeur 57. S'il est prévu de compter par exemple 200 alternances dans le premier compteur d'alternances, la fenêtre de mesure 53 est configurée pour que le second compteur d'alternances 54 compte un nombre d'alternances du signal de référence VR pendant une durée à peu près 5000 fois inférieure. Cette durée peut être dépendante aussi du temps de comptage par exemple des 200 alternances du premier compteur d'alternances 52. Cela permet de réduire la consommation électrique du circuit d'autorégulation.

Le début de comptage commandé par la fenêtre de mesure 53 peut être déterminé par le premier compteur d'alternances 52, mais peut aussi de préférence être commandé directement par l'unité de traitement à processeur 57. L'unité de traitement à processeur 57 peut recevoir tout d'abord le premier signal de comptage NP relatif à un premier nombre déterminé d'alternances comptées de la tension alternative VP dans un premier intervalle de temps. Ce premier signal de comptage est mémorisé par exemple dans un registre de l'unité de traitement à processeur. Par la suite, l'unité de traitement à processeur 57 peut recevoir le second signal de comptage NR relatif à un second nombre d'alternances comptées dans le second compteur d'alternances 54 dans un second intervalle de temps commandé par la fenêtre de mesure 53. Ce second signal de comptage NR peut aussi être mémorisé dans un autre registre de l'unité de traitement à processeur. Finalement une comparaison des deux signaux de comptage est effectuée dans l'unité de traitement à processeur 57 pour déterminer si la fréquence de la tension alternative VP est trop élevée ou trop basse par rapport proportionnellement à la fréquence du signal de référence.

Sur la base de la comparaison effectuée entre les deux signaux de comptage NP et NR dans l'unité de traitement à processeur, ladite unité de traitement à processeur commande une unité d'adaptation de fréquence 58, dont la sortie est reliée aux deux électrodes ou groupes d'électrodes de l'élément piézoélectrique 3. Cette unité d'adaptation de fréquence 58 peut être prévue pour fournir un signal d'adaptation de fréquence, qui est une tension continue VA, dont le niveau est fonction de la différence entre les deux signaux de comptage communiquée par l'unité de traitement à processeur. Un réseau commutable de condensateurs ou de résistances peut être prévu à cet effet. Il peut être fourni une valeur de tension continue par l'intermédiaire d'un suiveur de tension de l'unité d'adaptation 58 à une des électrodes ou groupes d'électrodes de l'élément piézoélectrique 3 ou à l'autre électrode ou groupe d'électrodes de l'élément piézoélectrique. Cela permet ainsi d'induire une certaine force sur l'élément piézoélectrique pour freiner ou accélérer l'oscillation du système mécanique oscillant en fonction de la comparaison des deux signaux de comptage.

Le circuit d'autorégulation 10 peut comprendre également des éléments de compensation thermique bien connus, ainsi qu'une unité de remise à zéro à chaque enclenchement du circuit d'autorégulation 10. Tous les composants électroniques du circuit d'autorégulation, ainsi que le résonateur MEMS 56 et le condensateur Cc font par exemple partie d'un même module électronique compact. Tous ces composants électroniques peuvent être intégrés avantageusement dans un même substrat silicium monolithique, ce qui permet de n'avoir qu'un seul module électronique autoalimenté pour la régulation de fréquence du système mécanique oscillant.

La description précédente de l'élément piézoélectrique selon l'invention a été faite en référence à un ressort spiral formé d'une bande en quartz monocristallin. Toutefois, le quartz utilisé en tant que cristal piézoélectrique n'est nullement limitatif dans le cadre de la présente invention, et d'autres cristaux piézoélectriques peuvent aussi être envisagés pour former le ressort spiral, tels que par exemple, sans que cette liste ne soit exhaustive, la topaze, la berlinite, le niobate de lithium, le tantalate de lithium, le phosphate de gallium, l'arséniate de gallium, le silicate d'aluminium, le dioxyde de germanium, un monocristal du groupe des tourmalines, un monocristal du groupe des semi-conducteurs III-V de structure zinc-blende ou encore un monocristal du groupe des semi-conducteurs II-VI de structure wurtzite.

Par conséquent, bien que la description de l'invention donnée ci-avant a été faite en référence à un changement de polarité des charges respectant une distribution angulaire périodique de 60°, due à la structure cristalline du quartz ; d'autres distributions angulaires périodiques peuvent également être envisagées sans sortir du cadre de l'invention définie par les revendications, selon les différents types de cristaux piézoélectriques utilisés pour former le ressort spiral.

En outre, la description précédente de l'élément piézoélectrique selon l'invention a été faite en référence à des couches discontinues constituées d'un oxyde en tant que matériau isolant. Un tel oxyde peut par exemple être choisi parmi la silice, l'alumine ou encore l'oxyde d'hafnium, sans que cette liste ne soit exhaustive. Par ailleurs, le choix d'un oxyde en tant que matériau isolant n'est nullement limitatif dans le cadre de la présente invention, et d'autres matériaux isolants peuvent être envisagés, tels que par exemple le nitrure de silicium.

## Revendications

1. Elément piézoélectrique (3) pour un circuit d'autorégulation de fréquence (10), l'élément piézoélectrique (3) comprenant :
- un ressort spiral (7) formé d'une bande en matériau piézoélectrique;
- au moins une première électrode (8a, 8c), destinée à être reliée au circuit d'autorégulation de fréquence (10), et disposée sur tout ou partie d'une face de la bande en matériau piézoélectrique;
- au moins une deuxième électrode (8b, 8d), destinée à être reliée au circuit d'autorégulation de fréquence (10), et disposée sur tout ou partie d'une face de la bande en matériau piézoélectrique, distincte de la face supportant la première électrode (8a, 8c);
**caractérisé en ce que** le matériau piézoélectrique est un cristal piézoélectrique ou une céramique piézoélectrique, et
**en ce que** l'élément piézoélectrique (3) comprend en outre au moins deux couches discontinues (12a-12d) d'un matériau isolant, chaque couche discontinue de matériau isolant étant disposée sur au moins une face de la bande en matériau piézoélectrique et séparant une dite première électrode (8a, 8c) d'une dite deuxième électrode (8b, 8d), les couches discontinues de matériau isolant étant réparties sur des portions prédéterminées (14) du ressort spiral (7) formant sensiblement des arcs de cercle, selon une périodicité angulaire prédéterminée.

2. Elément piézoélectrique (3) selon la revendication 1, **caractérisé en ce qu'**il comprend deux électrodes (8a, 8b) et deux couches discontinues (12a, 12b) de matériau isolant, la première électrode (8a) étant disposée sur tout ou partie d'une première face de la bande en matériau piézoélectrique ; la deuxième électrode (8b) étant disposée sur tout ou partie d'une deuxième face de la bande en matériau piézoélectrique, opposée à la première face ; une première couche discontinue (12a) de matériau isolant étant disposée sur une troisième face de la bande en matériau piézoélectrique ; une deuxième couche discontinue (12b) de matériau isolant étant disposée sur une quatrième face de la bande en matériau piézoélectrique, opposée à la troisième face.

3. Elément piézoélectrique (3) selon la revendication 1, **caractérisé en ce qu'**il comprend deux premières électrodes (8a, 8c), deux deuxièmes électrodes (8b, 8d) et quatre couches discontinues (12a-12d) de matériau isolant, les deux premières électrodes (8a, 8c) étant reliées en une première borne de connexion (26) destinée à être reliée au circuit d'autorégulation de fréquence (10), et étant disposées sur une première paire de faces opposées de la bande en matériau piézoélectrique ; les deux deuxièmes électrodes (8b, 8d) étant reliées en une deuxième borne de connexion (28) destinée à être reliée au circuit d'autorégulation de fréquence (10), et étant disposées sur une deuxième paire de faces opposées de la bande en matériau piézoélectrique ; chaque couche discontinue (12a-12d) de matériau isolant étant disposée à cheval sur une des faces de ladite première paire de faces et une des faces de ladite deuxième paire de faces de la bande en matériau piézoélectrique.

4. Elément piézoélectrique (3) selon l'une quelconque des revendications précédentes, **caractérisé en ce que** le cristal piézoélectrique est un monocristal.

5. Elément piézoélectrique (3) selon la revendication 4, **caractérisé en ce que** le cristal piézoélectrique est un monocristal choisi parmi le groupe consistant en la topaze, la berlinite, le niobate de lithium, le tantalate de lithium, le phosphate de gallium, l'arséniate de gallium, le silicate d'aluminium, le dioxyde de germanium, un monocristal du groupe des tourmalines, un monocristal du groupe des semi-conducteurs III-V de structure zinc-blende et un monocristal du groupe des semi-conducteurs II-VI de structure wurtzite.

6. Elément piézoélectrique (3) selon la revendication 4, **caractérisé en ce que** le cristal piézoélectrique est du quartz monocristallin.

7. Elément piézoélectrique (3) selon la revendication 6, **caractérisé en ce que** le ressort spiral (7) est usiné dans du quartz monocristallin de coupe Z.

8. Elément piézoélectrique (3) selon la revendication 6 ou 7, **caractérisé en ce que** la périodicité angulaire prédéterminée est sensiblement égale à 120°.

9. Elément piézoélectrique (3) selon l'une des revendications 6 à 8, **caractérisé en ce que** les arcs de cercle définissent chacun un secteur angulaire sensiblement égal à 60°.

10. Elément piézoélectrique (3) selon l'une quelconque des revendications précédentes, **caractérisé en ce qu'**il comprend en outre une première rainure (16a) creusée dans une première face supérieure de la bande en matériau piézoélectrique et une deuxième rainure (16b) creusée dans une deuxième face inférieure de la bande en matériau piézoélectrique, ladite première électrode (8a) étant disposée dans ladite première rainure (16a), ladite deuxième électrode étant disposée dans ladite deuxième rainure (16b).

11. Elément piézoélectrique (3) selon l'une quelconque des revendications précédentes, **caractérisé en ce que** le matériau isolant est un oxyde.

12. Elément piézoélectrique (3) selon l'une quelconque des revendications 1 à 10, **caractérisé en ce que** le matériau isolant est choisi parmi le groupe consistant en la silice, l'alumine, l'oxyde d'hafnium et le nitrure de silicium.

13. Système mécanique oscillant pour un circuit d'autorégulation de fréquence (10), comprenant un balancier (2) et un élément piézoélectrique (3) muni d'un ressort spiral (7), le ressort spiral (7) étant monté sur ledit balancier (2), **caractérisé en ce que** l'élément piézoélectrique (3) est conforme à l'une quelconque des revendications précédentes.

14. Dispositif (1) comprenant le système mécanique oscillant selon la revendication 13 et un circuit (10) d'autorégulation de la fréquence d'oscillation du système mécanique oscillant, ledit circuit d'autorégulation (10) comprenant un étage oscillateur (55) apte à fournir un signal de référence (V_{R}), des moyens (52, 53, 54, 57) de comparaison de fréquence entre deux signaux, et une unité d'adaptation de fréquence (58) reliée à l'élément piézoélectrique (3) du système mécanique oscillant et apte à fournir un signal d'adaptation de fréquence (V_{A}), **caractérisé en ce que** l'élément piézoélectrique (3) du système mécanique oscillant est apte à générer une tension alternative (V_{P}) à fréquence correspondant au système mécanique oscillant, les première et deuxième électrodes de l'élément piézoélectrique étant reliées au circuit d'autorégulation (10) de manière à recevoir de l'unité d'adaptation de fréquence (58) le signal d'adaptation de fréquence (V_{A}), sur la base du résultat d'une comparaison de fréquence, dans les moyens de comparaison de fréquence, entre la tension alternative (Vp) et le signal de référence (V_{R}).

15. Dispositif selon la revendication 14, **caractérisé en ce que** le circuit (10) d'autorégulation de la fréquence d'oscillation du système mécanique oscillant comprend en outre un redresseur (51) pour redresser la tension alternative (V_{P}) générée par l'élément piézoélectrique (3) et pour stocker la tension redressée sur au moins un condensateur (C_{C}) pour pouvoir alimenter en électricité le circuit d'autorégulation.

16. Dispositif (1) selon la revendication 14 ou 15, **caractérisé en ce que** l'étage oscillateur (55) du circuit d'autorégulation (10) comprend un circuit oscillant relié à un résonateur MEMS (56) pour fournir un signal oscillant, afin que l'étage oscillateur (55) fournisse le signal de référence (V_{R}), tous les composants électroniques du circuit d'autorégulation étant regroupés pour ne former qu'un unique module électronique.

17. Procédé de fabrication d'un élément piézoélectrique (3) selon l'une quelconque des revendications 1 à 12, **caractérisé en ce qu'**il comporte les étapes consistant à :
- usiner une bande en matériau piézoélectrique, tel qu'un cristal piézoélectrique ou une céramique piézoélectrique à partir d'une plaque en cristal ou céramique piézoélectrique,
- déposer une première électrode (8a, 8c) sur tout ou partie d'une première face de la bande en matériau piézoélectrique,
- déposer une deuxième électrode (8b, 8d) sur tout ou partie d'une deuxième face de la bande en matériau piézoélectrique,
- déposer, sur au moins deux faces de la bande en matériau piézoélectrique, au moins deux couches discontinues (12a-12d) d'un matériau isolant, de sorte que chaque couche discontinue (12a-12d) de matériau isolant sépare une dite première électrode (8a, 8c) d'une dite deuxième électrode (8b, 8d), et que les couches discontinues de matériau isolant soient réparties sur des portions prédéterminées (14) de la bande en matériau piézoélectrique,
- enrouler la bande en matériau piézoélectrique sous la forme d'un ressort spiral (7), les couches discontinues (12a-12d) de matériau isolant étant réparties sur des portions prédéterminées (14) de la bande en matériau piézoélectrique de sorte à former sensiblement des arcs de cercle sur le ressort spiral (7), selon une périodicité angulaire prédéterminée.

18. Procédé de fabrication selon la revendication 17, **caractérisé en ce que** le spiral piézoélectrique est usiné à partir d'une plaque monocristalline, telle qu'en quartz, **en ce qu'**une première couche de Au/Cr est ensuite structurée par photolithographie, **en ce que** le quartz est ensuite usiné par voie humide au moyen d'un acide fluorhydrique et en utilisant la couche de Au/cr comme un masque, **en ce que** la résine et la couche d'Au/cr sont retirées, **en ce qu'**une couche isolante, qui peut être un oxyde, un nitrure, un carbure ou un polymère, est déposée par pulvérisation cathodique ou évaporation sous vide, puis structurée par photolithographie et gravure humide, et **en ce que** les électrodes sont déposées à travers un masque ou structurées par photolithographie.

## Patentansprüche

1. Piezoelektrisches Element (3) für einen Schaltkreis zur Frequenzselbstregulierung (10), wobei das piezoelektrische Element (3) umfasst:
- eine Spiralfeder (7), gebildet aus einem piezoelektrischem Bandmaterial;
- mindestens eine erste Elektrode (8a, 8c), die zum Anschließen an den Schaltkreis zur Frequenzselbstregulierung (10) bestimmt ist, und auf einer gesamten Seite des piezoelektrischen Bandmaterials oder auf einem Teil hiervon angeordnet ist;
- mindestens eine zweite Elektrode (8b, 8d), die zum Anschließen an den Schaltkreis zur Frequenzselbstregulierung (10) bestimmt ist, und auf einer gesamten Seite des piezoelektrischen Bandmaterials, die von der die erste Elektrode (8a, 8c) tragenden Seite verschieden ist, oder auf einem Teil hiervon angeordnet ist;
**dadurch gekennzeichnet, dass** das piezoelektrische Material ein piezoelektrischer Kristall oder eine piezoelektrische Keramik ist und
dass das piezoelektrische Element (3) ferner mindestens zwei nicht zusammenhängende Schichten (12a-12d) eines Isoliermaterials umfasst, wobei jede nicht zusammenhängende Schicht aus Isoliermaterial mindestens auf einer Seite des Bandes aus piezoelektrischem Material angeordnet ist und eine erste Elektrode (8a, 8c) von einer zweiten Elektrode (8b, 8d) trennt, wobei die nicht zusammenhängenden Schichten aus Isoliermaterial auf vorbestimmten Abschnitten (14) der Spiralfeder (7), die im Wesentlichen Kreisbögen bilden, gemäß einer vorbestimmten Winkelperiodizität verteilt sind.

2. Piezoelektrisches Element (3) nach Anspruch 1, **dadurch gekennzeichnet, dass** es zwei Elektroden (8a, 8b) und zwei nicht zusammenhängende Schichten (12a, 12b) aus Isoliermaterial aufweist, wobei die erste Elektrode (8a) auf einer gesamten ersten Seite des piezoelektrischen Bandmaterials oder auf einem Teil hiervon angeordnet ist; die zweite Elektrode (8b) auf einer gesamten zweiten, der ersten Seite gegenüberliegenden Seite des piezoelektrischen Bandmaterials, oder auf einem Teil hiervon angeordnet ist; eine erste nicht zusammenhängende Schicht (12a) aus Isoliermaterial auf einer dritten Seite des piezoelektrischen Bandmaterials angeordnet ist; eine zweite nicht zusammenhängende Schicht (12b) aus Isoliermaterial auf einer vierten, der dritten Seite gegenüberliegenden Seite des piezoelektrischen Bandmaterials angeordnet ist.

3. Piezoelektrisches Element (3) nach Anspruch 1, **dadurch gekennzeichnet, dass** es zwei erste Elektroden (8a, 8c), zwei zweite Elektroden (8b, 8d) und vier nicht zusammenhängende Schichten (12a-12d) aus Isoliermaterial umfasst, wobei die beiden ersten Elektroden (8a, 8c) mit einer ersten Anschlussklemme (26), die zum Anschluss an den Schaltkreis zur Frequenzselbstregulierung (10) bestimmt ist, verbunden sind und auf einem ersten Paar gegenüberliegender Seiten des piezoelektrischen Bandmaterials angeordnet sind; die beiden zweiten Elektroden (8b, 8d) mit einer zweiten Anschlussklemme (28), die zum Anschließen an den Schaltkreis zur Frequenzselbstregulierung (10) bestimmt ist, verbunden sind und auf einem zweiten Paar gegenüberliegender Seiten des piezoelektrischen Bandmaterials angeordnet sind; wobei jede nicht zusammenhängende Schicht (12a-12d) aus Isoliermaterial beiderseits der Grenze zwischen einer der Seiten des ersten Paars von Seiten und einer der Seiten des zweiten Paars von Seiten des piezoelektrischen Bandmaterials angeordnet ist.

4. Piezoelektrisches Element (3) nach einem der vorhergehenden Ansprüche, **dadurch gekennzeichnet, dass** der piezoelektrische Kristall ein Einkristall ist.

5. Piezoelektrisches Element (3) nach Anspruch 4, **dadurch gekennzeichnet, dass** der piezoelektrische Kristall ein Einkristall ist, der aus der Gruppe ausgewählt ist, die aus Topas, Berlinit, Lithiumniobat, Lithiumtantalat, Galliumphosphat, Galliumarseniat, Aluminiumsilicat, Germaniumdioxid, einem Einkristall der Gruppe der Turmaline, einem Einkristall der Gruppe der III-V-Halbleiter mit Zinkblendenstruktur und einem Einkristall der Gruppe der II-VI-Halbleiter mit Wurtzitstruktur besteht.

6. Piezoelektrisches Element (3) nach Anspruch 4, **dadurch gekennzeichnet, dass** der piezoelektrische Kristall monokristalliner Quarz ist.

7. Piezoelektrisches Element (3) nach Anspruch 6, **dadurch gekennzeichnet, dass** die Spiralfeder (7) aus einem monokristallinen Quarz im Z-Schnitt herausgearbeitet ist.

8. Piezoelektrisches Element (3) nach Anspruch 6 oder 7, **dadurch gekennzeichnet, dass** die vorbestimmte Winkelperiodizität im Wesentlichen gleich 120° ist.

9. Piezoelektrisches Element (3) nach einem der Ansprüche 6 bis 8, **dadurch gekennzeichnet, dass** die Kreisbögen jeweils einen Winkelsektor im Wesentlichen gleich 60° definieren.

10. Piezoelektrisches Element (3) nach einem der vorhergehenden Ansprüche, **dadurch gekennzeichnet, dass** es ferner eine erste Rille (16a), die in einer ersten, oberen Seite des piezoelektrischen Bandmaterials ausgespart ist, und eine zweite Rille (16b), die in einer zweiten, unteren Seite des piezoelektrischen Bandmaterials ausgespart ist, aufweist, wobei die erste Elektrode (8a) in der ersten Rille (16a) angeordnet ist und die zweite Elektrode in der zweiten Rille (16b) angeordnet ist.

11. Piezoelektrisches Element (3) nach einem der vorhergehenden Ansprüche, **dadurch gekennzeichnet, dass** das Isoliermaterial ein Oxid ist.

12. Piezoelektrisches Element (3) nach einem der Ansprüche 1 bis 10, **dadurch gekennzeichnet, dass** das Isoliermaterial aus der Gruppe ausgewählt ist, die aus Siliziumoxid, Aluminiumoxid, Hafniumoxid und Siliziumnitrid besteht.

13. Schwingendes mechanisches System, für einen Schaltkreis zur Frequenzselbstregulierung (10), umfassend eine Unruh (2) und ein mit einer Spiralfeder (7) versehenes piezoelektrisches Element (3), wobei die Spiralfeder (7) an der Unruh (2) montiert ist, **dadurch gekennzeichnet, dass** das piezoelektrische Element (3) gemäß einem der vorhergehenden Ansprüche beschaffen ist.

14. Vorrichtung (1), umfassend das schwingende mechanische System nach Anspruch 13 und einen Schaltkreis zur Frequenzselbstregulierung (10) des schwingenden mechanischen Systems, wobei der Schaltkreis zur Selbstregulierung (10) eine Oszillatorstufe (55), die geeignet ist, ein Referenzsignal (VR) zu liefern, Mittel (52, 53, 54, 57) zum Vergleichen der Frequenz von zwei Signalen und eine Frequenzanpassungseinheit (58) umfasst, die mit dem piezoelektrischen Element (3) des schwingenden mechanischen Systems verbunden ist und geeignet ist, ein Frequenzanpassungssignal (VA) zu liefern, **dadurch gekennzeichnet, dass** das piezoelektrische Element (3) des schwingenden mechanischen Systems geeignet ist, eine Wechselspannung (VP) mit einer dem schwingenden mechanischen System entsprechenden Frequenz zu erzeugen, wobei die erste und die zweite Elektrode des piezoelektrischen Elements mit dem Schaltkreis zur Selbstregulierung (10) verbunden sind, um von der Frequenzanpassungseinheit (58) das Frequenzanpassungssignal (VA) auf der Basis des Ergebnisses eines Frequenzvergleichs in den Frequenzvergleichsmitteln zwischen der Wechselspannung (VP) und dem Referenzsignal (VR) zu empfangen.

15. Vorrichtung nach Anspruch 14, **dadurch gekennzeichnet, dass** der Schaltkreis zur Selbstregulierung (10) der Schwingungsfrequenz des schwingenden mechanischen Systems ferner einen Gleichrichter (51) umfasst, um die durch das piezoelektrische Element (3) erzeugte Wechselspannung (VP) gleichzurichten und um die gleichgerichtete Spannung in mindestens einem Kondensator (C_{C}) zu speichern, um den Schaltkreis zur Selbstregulierung mit Elektrizität versorgen zu können.

16. Vorrichtung (1) nach Anspruch 14 oder 15, **dadurch gekennzeichnet, dass** die Oszillatorstufe (55) des Schaltkreises zur Selbstregulierung (10) einen Schwingkreis umfasst, der mit einem MEMS-Resonator (56) verbunden ist, um ein Schwingungssignal zu liefern, damit die Oszillatorstufe (55) das Referenzsignal (VR) liefert, wobei sämtliche elektronischen Komponenten des Schaltkreises zur Selbstregulierung so gruppiert sind, dass sie nur ein einziges elektronisches Modul bilden.

17. Verfahren zum Herstellen eines piezoelektrischen Elements (3) nach einem der Ansprüche 1 bis 12, **dadurch gekennzeichnet, dass** es die folgenden Schritte umfasst:
- Fertigen eines Bandes aus piezoelektrischem Material wie etwa einem piezoelektrischen Kristall oder einer piezoelektrischen Keramik ausgehend von einer Kristallplatte oder einer piezoelektrischen Keramik,
- Bilden einer ersten Elektrode (8a, 8c) auf einer gesamten ersten Seite des Bandes aus piezoelektrischem Material oder auf einem Teil hiervon,
- Bilden einer zweiten Elektrode (8b, 8d) auf einer gesamten zweiten Seite des Bandes aus piezoelektrischem Material oder auf einem Teil hiervon,
- Ablagern mindestens zweier nicht zusammenhängender Schichten (12a-12d) aus einem Isoliermaterial mindestens auf zwei Seiten des piezoelektrischen Bandmaterials, derart, dass jede nicht zusammenhängende Schicht (12a-12d) aus Isoliermaterial eine erste Elektrode (8a, 8c) von einer zweiten Elektrode (8b, 8d) trennt und dass die nicht zusammenhängenden Schichten aus Isoliermaterial auf vorgegebenen Abschnitten (14) des piezoelektrischen Bandmaterials verteilt sind,
- Aufwickeln des piezoelektrischen Bandmaterials in Form einer Spiralfeder (7), wobei die nicht zusammenhängenden Schichten (12a-12d) aus Isoliermaterial auf vorbestimmten Abschnitten (14) des piezoelektrischen Bandmaterials verteilt sind, derart, dass sie auf der Spiralfeder (7) im Wesentlichen Kreisbögen mit einer vorgegebenen Winkelperiodizität bilden.

18. Herstellungsverfahren nach Anspruch 17, **dadurch gekennzeichnet, dass** die piezoelektrische Spirale ausgehend von einer monokristallinen Platte etwa aus Quarz gefertigt wird, dass eine erste Schicht aus Au/Cr anschließend durch Photolithographie strukturiert wird, dass der Quarz anschließend mittels Fluorwasserstoffsäure und unter Verwendung der Schicht aus Au/Cr als Maske feucht bearbeitet wird, dass das Harz und die Schicht aus Au/Cr entfernt werden, dass eine Isolierschicht, die ein Oxid, ein Nitrid, ein Carbid oder ein Polymer sein kann, durch Katodenzerstäubung oder Vakuumdampfabscheidung abgelagert und dann durch Photolithographie und Feuchtätzung strukturiert wird, und dass die Elektroden durch eine Maske hindurch abgelagert oder durch Photolithographie strukturiert werden.

## Claims

1. Piezoelectric element (3) for an automatic frequency control circuit (10), the piezoelectric element (3) comprising:
- a balance spring (7) formed of a strip of piezoelectric material;
- at least a first electrode (8a, 8c), intended to be connected to the automatic frequency control circuit (10), and disposed on all or part of one side of the strip of piezoelectric material;
- at least a second electrode (8b, 8d) intended to be connected to the automatic frequency control circuit (10), and disposed on all or part of one side of the strip of piezoelectric material, distinct from the side carrying the first electrode (8a, 8c);
**characterized in that** the piezoelectric material is a piezoelectric crystal or a piezoelectric ceramic, and
**in that** the piezoelectric element (3) further comprises at least two discontinuous layers (12a-12d) of an insulating material, each discontinuous layer of insulating material being disposed on at least one side of the strip of piezoelectric material and separating a said first electrode (8a, 8c) from a said second electrode (8b, 8d), the discontinuous layers of insulating material being distributed on predetermined portions (14) of the balance spring (7) substantially forming arcs, in a predetermined angular periodicity.

2. Piezoelectric element (3) according to claim 1, **characterized in that** said element includes two electrodes (8a, 8b) and two discontinuous layers (12a, 12b) of insulating material, the first electrode (8a) being disposed on all or part of a first side of the strip of piezoelectric material; the second electrode (8b) being disposed on all or part of a second side of the strip of piezoelectric material, opposite to the first side; a first discontinuous layer (12a) of insulating material being disposed on a third side of the strip of piezoelectric material; a second discontinuous layer (12b) of insulating material being disposed on a fourth side of the strip of piezoelectric material, opposite to the third side.

3. Piezoelectric element (3) according to claim 1, **characterized in that** said element includes two first electrodes (8a, 8c), two second electrodes (8b, 8d) and four discontinuous layers (12a-12d) of insulating material, the two first electrodes (8a, 8c) being connected in a first connection terminal (26) intended to be connected to the automatic frequency control circuit (10), and being disposed on a first pair of opposite sides of the strip of piezoelectric material; the two second electrodes (8b, 8d) being connected in a second connection terminal (28) intended to be connected to the automatic frequency control circuit (10), and being disposed on a second pair of opposite sides of the strip of piezoelectric material; each discontinuous layer (12a-12d) of insulating material being disposed astride on one of the faces of said first pair of faces and one of the faces of said second pair of faces of the strip of piezoelectric material.

4. Piezoelectric element (3) according to any of the preceding claims, **characterized in that** the piezoelectric crystal is a single crystal.

5. Piezoelectric element (3) according to claim 4, **characterized in that** the piezoelectric crystal is a single crystal chosen from the group consisting of topaz, berlinite, lithium niobate, lithium tantalate, gallium phosphate, gallium arsenate, aluminium silicate, germanium dioxide, a single crystal tourmaline, a single crystal from the group of zinc blende structure III-V semiconductors, or a single crystal from the group of wurtzite structure II-VI semiconductors.

6. Piezoelectric element (3) according to claim 4, **characterized in that** the piezoelectric crystal is single crystal quartz.

7. Piezoelectric element (3) according to claim 6, **characterized in that** the balance spring (7) is machined in Z-cut single crystal quartz.

8. Piezoelectric element (3) according to claim 6 or 7, **characterized in that** the predetermined angular periodicity is substantially equal to 120°.

9. Piezoelectric element (3) according to any of claims 6 to 8, **characterized in that** the arcs each define an angular sector substantially equal to 60°

10. Piezoelectric element (3) according to any of the preceding claims, **characterized in that** said element also includes a first groove (16a) made in a first upper side of the strip of piezoelectric material and a second groove (16b) made in a second lower side of the piezoelectric material strip, said first electrode (8a) being disposed in said first groove (16a), said second electrode being disposed in said second groove (16b).

11. Piezoelectric element (3) according to any of the preceding claims, **characterized in that** the insulating material is an oxide.

12. Piezoelectric element (3) according to any of claims 1 to 10, **characterized in that** the insulating material is chosen from the group comprising silica, alumina, hafnium oxide and silicon nitride.

13. Oscillating mechanical system for an automatic frequency control circuit (10), comprising a balance (2) and a piezoelectric element (3) provided with a balance spring (7), the balance spring (7) being mounted on said balance (2), **characterized in that** the piezoelectric element (3) conforms to any of the preceding claims.

14. Device (1) comprising the oscillating mechanical system according to claim 13 and a circuit (10) for automatic control of the oscillation frequency of the oscillating mechanical system, said automatic control circuit (10) including an oscillator stage (55) able to provide a reference signal (V_{R}), means for comparing the frequency (52, 53, 54, 57) of two signals, and a frequency adaptation unit (58) connected to the piezoelectric element (3) of the oscillating mechanical system and able to provide a frequency adaptation signal (V_{A}), **characterized in that** the piezoelectric element (3) of the oscillating mechanical system is able to generate an alternating voltage (V_{P}) at a frequency matching the oscillating mechanical system, the first and second electrodes of the piezoelectric element being connected to the automatic control circuit (10) in order to receive from the frequency adaptation unit (58) the frequency adaptation signal (V_{A}), based on the result of a frequency comparison, in the frequency comparison means, between the alternating signal (V_{P}) and the reference signal (V_{R}).

15. Device according to claim 14, **characterized in that** the circuit (10) for automatic control of the oscillation frequency of the oscillating mechanical system further includes a rectifier (51) for rectifying the alternating voltage (V_{P}) generated by the piezoelectric element (3) and for storing the rectified voltage across at least one capacitor (C_{C}), in order to supply the automatic control circuit with electricity.

16. Device (1) according to claim 14 or 15, **characterized in that** the oscillator stage (55) of the automatic control circuit (10) includes an oscillating circuit connected to a MEMS resonator (56) to provide an oscillating signal, so that the oscillator stage (55) provides the reference signal (V_{R}), all the electronic components of the automatic control circuit being grouped together to form a single electronic module.

17. Method for manufacturing a piezoelectric element (3) according to any of claims 1 to 12, **characterized in that** the method includes the steps consisting in:
- machining a strip of piezoelectric material, such as a piezoelectric crystal or a piezoelectric ceramic from a crystal or piezoelectric ceramic plate,
- placing a first electrode (8a, 8c) on all or part of a first side of the strip of piezoelectric material,
- placing a second electrode (8b, 8d) on all or part of a second side of the strip of piezoelectric material,
- placing, on at least two faces of the strip of piezoelectric material, at least two discontinuous layers (12a-12d) of an insulating material, so that each discontinuous layer (12a-12d) of insulating material separates a said first electrode (8a, 8c) from a said second electrode (8b, 8d), and so that the discontinuous layers of insulating material are distributed over predetermined portions (14) of the strip of piezoelectric material,
- winding the strip of piezoelectric material into the shape of a balance spring (7), the discontinuous layers (12a-12d) of insulating material being distributed over predetermined portions (14) of the strip of piezoelectric material, so as to form substantially arcs on the balance spring (7), with a predetermined angular periodicity.

18. Manufacturing method according to claim 17, **characterized in that** the piezoelectric balance spring is machined from a single crystal plate, such as a quartz plate, **in that** a first layer of Au/Cr is then structured by photolithography, **in that** the quartz is then machined by wet means using a hydrofluoric acid and using the Au/Cr layer as a mask, **in that** the resin and the Au/Cr layer are removed, **in that** an insulating layer, which may be an oxide, a nitride, a carbide or a polymer, is deposited by cathodic sputtering or vacuum deposition, then structured by photolithography and wet etching, and **in that** the electrodes are deposited through a mask or structured by photolithography.
